(19) Europäisches Patentamt

European Patent Office

Office européen des brevets

(11) **EP 1 679 524 A1**

(12) **EUROPEAN PATENT APPLICATION**

(43) Date of publication:
**12.07.2006 Bulletin 2006/28**

(51) Int Cl.:
*G01R 33/07* (2006.01)

(21) Application number: **05100131.1**

(22) Date of filing: **11.01.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **ECOLE POLYTECHNIQUE FEDERALE DE LAUSANNE EPFL - STI - IMM - LMIS3 1015 Lausanne (CH)**

(72) Inventors:
• **Popovic, Radivoje 1025, St-Sulpice (CH)**

• **Drljaca, Predrag 1700, Fribourg (CH)**
• **Kejik, Pavel 1024, Ecublens (CH)**
• **Boero, Giovanni 1022, Chavannes-pres-Renens (CH)**

(74) Representative: **Falk, Urs et al Patentanwaltsbüro Dr. Urs Falk, Eichholzweg 9A 6312 Steinhausen (CH)**

(54) **Hall sensor and method of operating a Hall sensor**

(57) A Hall sensor comprises a Hall element (1; 30; 31; 60) and an amplifier (2; 32; 33). The Hall element is placed inside the amplifier so that the current flowing through the Hall element also flows through the transistors of an amplifier stage of the amplifier. The current flowing through the Hall element flows for example through the transistors of an input stage of the amplifier. In doing so the current consumption of the Hall sensor is reduced to the current the amplifier consumes itself.

The Hall sensor is preferably operated in a modified spinning current that preserves the correlation of the noise as far as possible. Preferably, the current flowing through the Hall element is pulsed. This mode of operation is useful for applications based on a battery as power supply. The signal to noise ratio related to the power consumption increases. A pulsed operation means that the current flowing through the Hall element is switched on and off with a predetermined frequency.

Fig. 1

EP 1 679 524 A1

**Description**

The invention concerns a Hall sensor of the type named in the preamble of claim 1 and a method of operating a Hall sensor.

A Hall sensor within the context of the present invention is a sensor comprising at least one Hall element, a current source and an amplifier. A Hall element is an element showing the Hall effect, which is a galvanomagnetic effect that arises when a current flows through a material in the presence of a magnetic field. Hall elements are described for example in the book "Hall effect devices, 2ed, IOP, 2004" of R.S. Popovic. A Hall element comprises four terminals, namely two current terminals and two voltage terminals. A current passing through the Hall element generates a Hall voltage proportional to the magnitude of the current and the external magnetic field. The output signal of the Hall element consists of the Hall voltage, a noise voltage and an offset voltage. The noise voltage comprises thermal noise and low frequency 1/f noise. The offset voltage is a DC voltage resulting from unavoidable geometrical tolerances of the Hall element, crystal defects, stress, etc.

It is known, for example from "Allegro, Linear Hall Sensors, App. Note 27702A", to reduce the offset voltage and the low frequency 1/f noise by using a switching technique that alternately exchanges the current and voltage terminals. In doing so, the direction of the current and the sign of the Hall voltage are changed simultaneously, whereas the sign of the offset voltage remains the same. The Hall voltage now appears as an AC voltage and the offset voltage and low frequency 1/f noise appear as a DC voltage. The output voltage of the Hall element is amplified, filtered and demodulated in order to get a DC signal representing the strength of the external magnetic field.

An improvement of this switching technique is known from DT 2333080. This improved switching technique is well known in the art as "Spinning current method". It consists in that the four terminals of the Hall element are connected in four phases following each other in such a way with the current source and the amplifier, respectively, that the direction of the current flowing through the Hall element rotates clockwise or counterclockwise. However, these improvements of the switching technique bring the disadvantage of an increase in thermal noise.

The object of the invention is to develop a Hall sensor with further improved noise properties, i.e. an enlarged signal to noise ratio.

The invention is characterized in claims 1, 4, 5 and 7. Improvements of the invention result from the dependent claims.

The output signal of the Hall element must always be amplified. The amplifier is a source of additional noise that has to be minimized as well in order to maximize the overall signal to noise ratio of the Hall sensor.

According to a first aspect of the invention, the Hall element is placed inside the amplifier so that the current flowing through the Hall element also flows through the transistors of an amplifier stage of the amplifier. The current flows for example through the transistors of an input stage of the amplifier. However, the current could alternatively flow through another stage of the amplifier, e.g. a feedback stage or an output stage, or, if more than one amplifier is present, the current flowing through the Hall element could flow through any of the amplifiers. In doing so the current consumption of the Hall sensor is reduced to the current the amplifier consumes itself. If possible, the Hall element is placed in that stage of the amplifier that consumes the highest current.

The idea to reduce the overall current consumption by using a current flowing through a Hall element also for the operation of the amplifier stage can be extended if the Hall sensor comprises more than one Hall element and more than one amplifier. Instead of having a Hall element and an amplifier sharing the same current, the Hall elements may be connected in series and the amplifiers may be connected in series so that a current flowing through the first Hall element also flows through the second Hall element and that a current used to operate the first amplifier is also used to operate the second amplifier.

According to a second aspect of the invention the known spinning current method is modified in that the sequence of the four phases is changed in order to minimize the noise produced by the switches. With the known spinning current method the eight switches are switched at the beginning of each of the four phases. Because the noise of two different switches is always uncorrelated, no correlation exists between the noise of the switches between any two phases following each other. The invention consists in that the four switches, that contact the two inputs of the amplifier with the terminals of the Hall element, are switched as seldom as possible in order to preserve the correlation of the noise as far as possible. According to the invention the direction of the current is reversed when changing from the first phase to the second phase, the current and voltage terminals are exchanged when changing from the second phase to the third phase, the direction of the current is reversed when changing from the third phase to the fourth phase and the current and voltage terminals are exchanged when changing from the fourth phase to the first phase of the next cycle. So when changing from the first phase to the second phase and from the third phase to the fourth phase the switches connecting the inputs of the amplifier with the Hall element are not switched.

According to a third aspect of the invention the current flowing through the Hall element is pulsed while keeping the overall current consumption constant. This mode of operation is useful for applications based on a battery as power supply. The signal to noise ratio related to the power consumption increases. A pulsed operation means that the current flowing through the Hall element is switched on and off with a predetermined frequency. Therefore in relation to the consumed power the strength of the current flowing through the Hall element in the pulsed mode of operation is bigger than the strength of the current flowing in the constant mode of operation.

The accompanying drawings, which are incorporated into and constitute a part of this specification, illustrate one or more embodiments of the present invention and, together with the detailed description, serve to explain the principles and implementations of the invention. The figures are not to scale.

In the drawings:

Fig. 1          shows a Hall sensor having a Hall element integrated into an amplifier,
Fig. 2          shows a Hall sensor having two Hall elements integrated into two amplifiers,
Fig. 3          shows a Hall sensor having two Hall elements integrated into an amplifier,
Fig. 4          shows a Hall sensor having two Hall elements and two amplifiers,
Figs. 5A-D    show the application of an improved spinning current method, and
Fig. 6          shows a pulsed mode of operation of the Hall sensor.

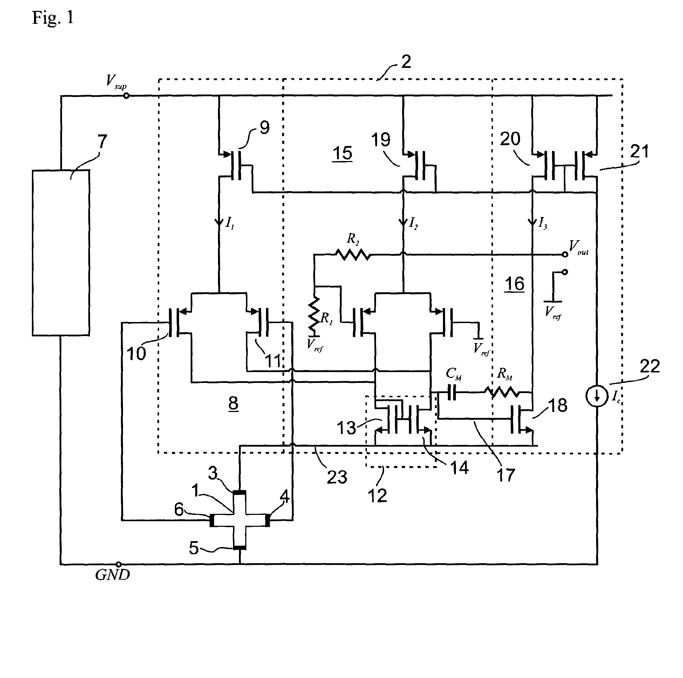

Fig. 1 shows a Hall sensor according to a first embodiment of the invention. The Hall sensor comprises a Hall element 1 and an amplifier 2, both integrated together into a single integrated circuit in a CMOS technology. In this example the amplifier 2 is a Differential Difference Amplifier, known in the art also as DDA amplifier. The Hall element 1 has four terminals, two terminals 3 and 5 used as current contacts and two terminals 4 and 6 used as voltage contacts. The integrated circuit is supplied with power from a battery 7 the electrical potentials of which are designated with $V_{sup}$ and GND (ground). The Hall element 1 is placed in a current path of the amplifier 2. The amplifier 2 comprises an input stage 8 that comprises a current source 9, a pair of PMOS transistors 10, 11 serving as high ohmic inputs for the voltages appearing at the voltage terminals 4 and 6 and a current mirror 12 consisting of a pair of NMOS transistors 13, 14 that make sure that a current of the same strength flows through each of the PMOS transistors 10, 11. The current source 9 is a PMOS transistor. The amplifier 2 further comprises a feedback stage 15 and an output stage 16, both comprising further MOS transistors, resistors and condensators. The currents $I_1$, $I_2$ and $I_3$ flowing through the input stage 8, the feedback stage 15 and the output stage 16, respectively, are defined by the current source 9, a current source 19 and a current source 20 coupled to a current mirror 21 that is controlled by a current source 22 providing a current $I_c$. The feedback stage 15 and the output stage 16 are explained only briefly: The feedback stage 15 and the input stage 8 share the current mirror 12 so they have a single common output node 17. The feedback stage 15 serves to define a DDA closed loop gain defined by resistors $R_1$ and $R_2$. The output stage 16 is an inverter, consisting of an NMOS transistor 18 operating in class A loaded with the current source 20. A capacitor $C_M$ and a resistor $R_M$ serve to stabilize the amplifier 2.The output voltage $V_{out}$ of the amplifier 2 is proportional to the voltage difference appearing at the Hall voltage terminals 4 and 6 and is defined in relation to a reference voltage $V_{ref}$. The invention concerns the placement of the Hall element 1 within a current path of the amplifier 2 so that the current flowing through the Hall element 1 is also used for the amplification of the Hall voltage. With this example the current $I_2$ flowing through the feedback stage 15 and the current $I_3$ flowing through the output stage 16 sum up at a common node 23 so that a current $I_H = I_1 + I_2 + I_3$ flows through the Hall element 1. The current $I_c$ may be much smaller than the currents $I_1$, $I_2$ and $I_3$ so that nearly all of the current delivered by the battery 7 flows through the Hall element 1 and the amplifier 2.

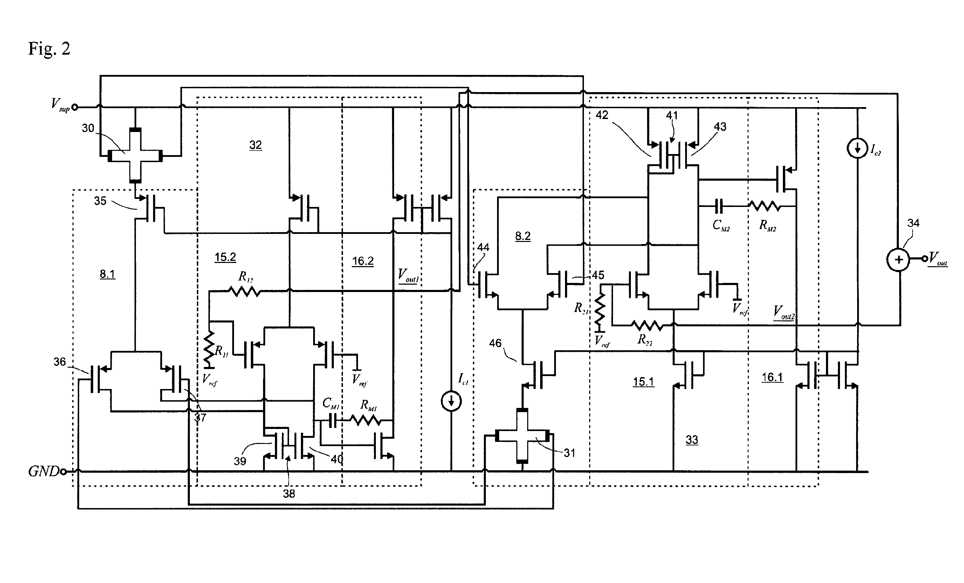

Fig. 2 shows a Hall sensor according to a second embodiment of the invention. The Hall sensor is supplied with power from a power source, e.g. a battery, delivering a constant voltage $V_{sup}$ with regard to a ground voltage GND. The Hall sensor comprises two Hall elements 30 and 31, two amplifiers 32 and 33, preferably DDA's, and, optionally, a summing junction 34 for summing the output voltages $V_{out1}$ and $V_{out2}$. The output voltage $V_{out1}$ is proportional to the Hall voltage of the first Hall element 30. The output voltage $V_{out2}$ is proportional to the Hall voltage of the second Hall element 31. At the output of the summing junction 34 a voltage $V_{out}$ appears that is proportional to the sum of the Hall voltages of the Hall elements 30 and 31. The two amplifiers 32 and 33 have a complementary construction. They each comprise an input stage 8.1 or 8.2, a feedback stage 15.1 or 15.2 and an output stage 16.1 or 16.2. The feedback stages and the output stages are for example designed like the feedback stage and output stage show in fig. 1. Therefore details of the feedback stages 15.1 and 15.2 and the output stages 16.1 and 16.2 are not shown.

The first Hall element 30 is placed in the current path of the input stage 8.1 of the first amplifier 32, the second Hall element 31 is placed in the current path of the input stage 8.2 of the second amplifier 33. The input stage 8.1 of the first amplifier 32 comprises a first current source 35, two PMOS transistors 36, 37 arranged in parallel and a first current mirror 38 consisting of two NMOS transistors 39, 40. The current mirror 38 makes sure that the same current flows through the first and second PMOS transistor 36 and 37. The first Hall element 30, the first current source 35, the PMOS transistors 36, 37 and the first current mirror 38 are connected in series, so that the current controlled by the first current source 35 first flows through the first Hall element 30, then through the first current source 35 and then at equal parts through the two PMOS transistors 36, 37 and finally through the current mirror 38. The input stage 8.2 of the second amplifier 33 is designed complementary to the first amplifier 32: It consists of a second current mirror 41 consisting of two PMOS transistors 42, 43, two NMOS transistors 44, 45 and a second current source 46. The second current mirror 41, the NMOS transistors 44, 45, the second current source 46 and the second Hall element 31 are connected in series, so that the current controlled by the second current source 46 first flows through the second current mirror 41, at equal parts through the two NMOS transistors 44, 45, the second current source 46 and finally through the second Hall element 31. The voltage terminals of the first Hall element 30 are each connected to a gate of the NMOS transistors 44 or 45 of the input stage 8.2 of the second amplifier 33. The voltage terminals of the second Hall element 31 are each connected to a gate of the PMOS transistors 36 or 37 of the input stage 8.1 of the first amplifier 32.

In the Hall sensor according to fig. 1 the currents flowing through the input stage, the feedback stage and the output stage join and then flow through the Hall element. In the Hall sensor according to fig. 2 the current flowing through the Hall element only flows through the input stage of the respective amplifier.

The Hall sensor is preferably operated in the pulsed mode and/or with the switching technique so that the voltages $V_{out1}$, $V_{out2}$ and $V_{out}$ are AC voltages. The pulsed mode of operation and the invented improved switching technique are explained in more detail later.

If the optional summing junction 34 is missing, then the output voltages $V_{out1}$ and $V_{out2}$ can be used separately to deliver two individual signals representing the local magnetic field present in the area of the first Hall element 30 or in the area of the second Hall element 31, respectively.

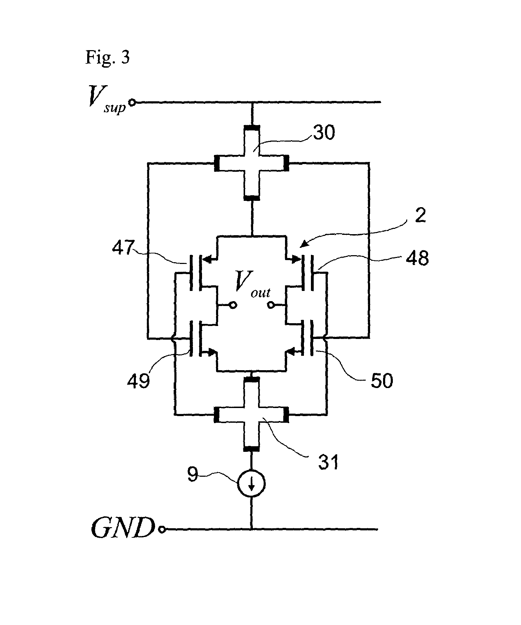

Fig. 3 shows a Hall sensor according to a third embodiment of the invention. The Hall sensor comprises a first Hall element 30, an amplifier 2, a second Hall element 31 and a current source 9 connected in series and supplied with a voltage $V_{sup}$ relative to GND from a power supply. The amplifier 2 comprises two PMOS transistors 47, 48 and two NMOS transistors 49, 50. The PMOS transistor 47 and the NMOS transistor 49 are connected in series, and the PMOS transistor 48 and the NMOS transistor 50 are connected in series. The Hall terminals of the first Hall element 30 are connected to the gates of the NMOS transistors 49, 50, the Hall terminals of the second Hall element 31 are connected to the gates of the PMOS transistors 47, 48. The output voltage $V_{out}$ appearing between the drains of the PMOS transistors 47, 48 is proportional to the Hall voltage and is further processed according to the needs of the application. It could for example as in the previous examples be fed to a feedback stage and an output stage.

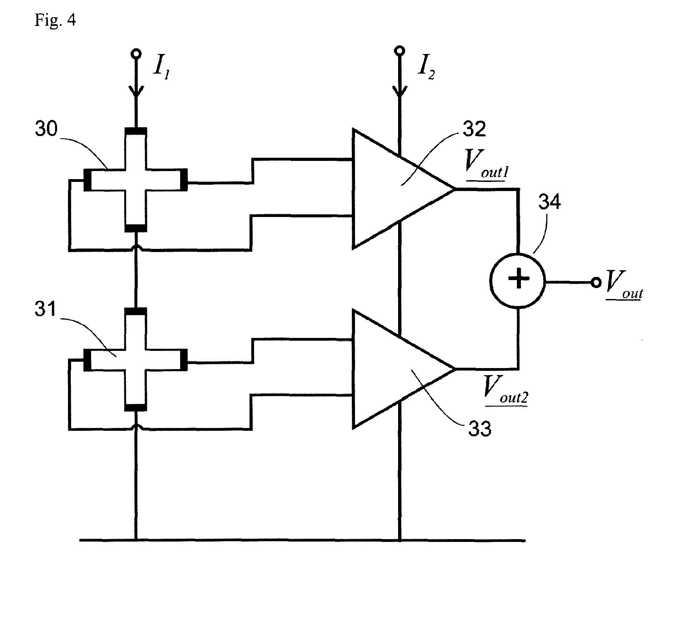

In the previous examples a Hall element and an amplifier shared the current, i.e. the current flowing through the Hall element also flows through a stage of the amplifier. If the Hall sensor comprises more than one Hall element and more than one amplifier, currents flowing through the Hall elements and the amplifiers can be shared in another way as illustrated in Fig. 4.

The Hall sensor of Fig. 4 comprises two Hall elements 30 and 31 connected in series and two amplifiers 32 and 33, preferably DDA amplifiers, connected in series. Two terminals of the first Hall element 30 are connected to two inputs of the first amplifier 32 and two terminals of the second Hall element 31 are connected to two inputs of the second amplifier 33. So a current $I_1$ flows first through the first Hall element 30 and then through the second Hall element 31 and a current $I_2$ needed to operate the first amplifier 32 is also used to operate the second amplifier 33. The output voltages $V_{out1}$ and $V_{out2}$ of the first and second amplifier 32 and 33, respectively, are summed up in a summing junction 34 or are further processed individually.

It is to be noted that the invention is not limited to CMOS technology. PMOS and NMOS transistors in the amplifiers can be replaced by corresponding bipolar PNP and NPN transistors. Furthermore the structure of the amplifier can be designed according to the advantages and/or needs of the technology.

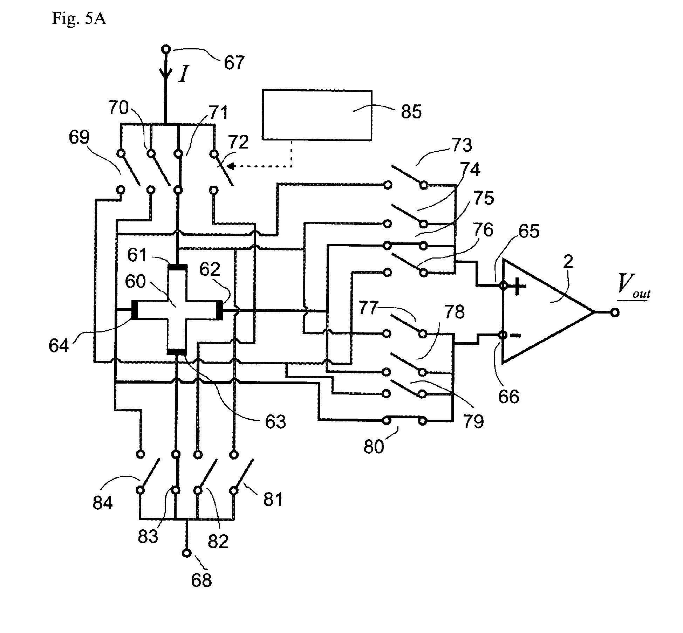

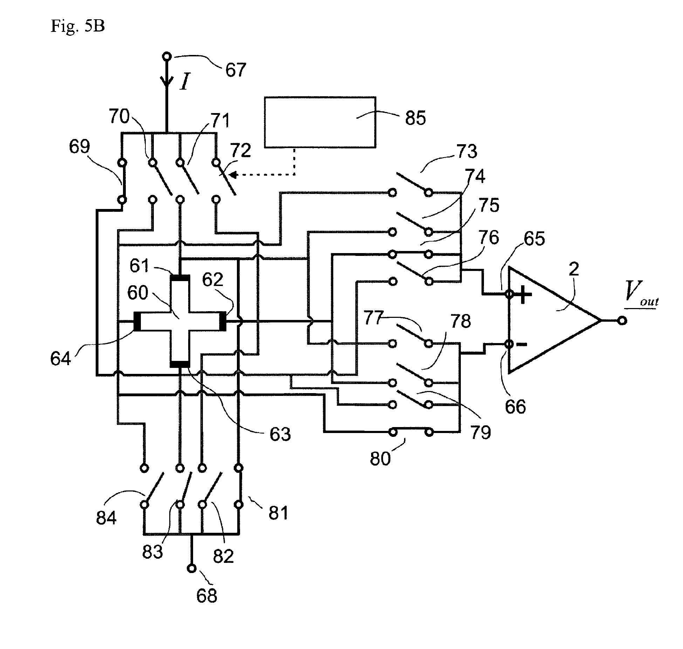

In the following, the switching technique according to the invention and the pulsed mode of operation according to the invention are explained. In order to reduce the offset voltage and the low frequency 1/f noise of the Hall element a switching technique is preferably applied. This can be the "conventional spinning current" method or the improved method according to the invention. In any case, the switching technique requires the Hall element to be an electrically symmetrical Hall effect device, such as a standard cross, a square, etc. With an electrically symmetrical Hall element the electrical properties are invariant with regard to an exchange of the current and voltage terminals. An electrically symmetrical Hall element can be a so-called horizontal Hall element which is sensitive to a magnetic field that is perpendicular to its surface or a so-called vertical Hall element which is sensitive to a magnetic field parallel to its surface. Horizontal Hall elements are for example known from EP 148330, electrically symmetrical vertical Hall elements are for example known from EP 362493. The Hall element may be produced using any material such as Si, GaAs, InSb or other hetero-structures. According to the invention the signal to noise ratio of the Hall sensor can be increased if the contribution of the switches to the noise is taken into account in that the correlation of the noise during the four phases of a switching cycle is maintained as far as possible. Figs. 5A to 5D show an electrically symmetrical Hall element 60 having four terminals 61 - 64, an amplifier 2 having two inputs terminals 65 and 66, two connection points 67 and 68, sixteen switches 69 - 84 and control means 85 for controlling the state of the sixteen switches according to a predetermined time scheme (for the sake of clarity of the illustration only one control line is shown). Four switches are assigned to each terminal of the Hall element 60. A current is supplied from a current supplying means to the first connection point 67, flows through the Hall element 60 and is lead away from the second connection point 68. With the embodiments shown above, the current supplying means is the current source 9 (Figs. 1, 4, 3), the current source 35 (Fig. 2) or the current source 46 (Fig. 2), respectively.

Figs. 5A to 5D show the state of the switches in four phases following each other of a complete switching cycle. During each phase four switches are closed and twelve switches are open. Fig. 5A shows the state of the switches 69 - 84 in the first phase. The four switches 71, 75, 80 and 83 are closed and the other twelve switches are open. So the current fed to the first connection point 67 enters the Hall element at terminal 61 and leaves the Hall element at terminal 63. The voltage difference appearing between the terminals 62 and 64 is applied to the input terminals 65 and 66 of the amplifier 2.

When changing from the first phase to the second phase the switches 71 and 83 are opened and the switches 69 and 81 are closed, so that now the current fed to the first connection point 67 enters the Hall element 60 at terminal 63 and leaves the Hall 60 element at terminal 61, i.e. it flows through the Hall element 60 in the reverse direction with regard to the first phase. The input terminals 65 and 66 of the amplifier 2 remained connected to the same terminals of the Hall element 60. The sign of the Hall voltage therefore reverses. Fig. 5B shows the state of the switches in the second phase.

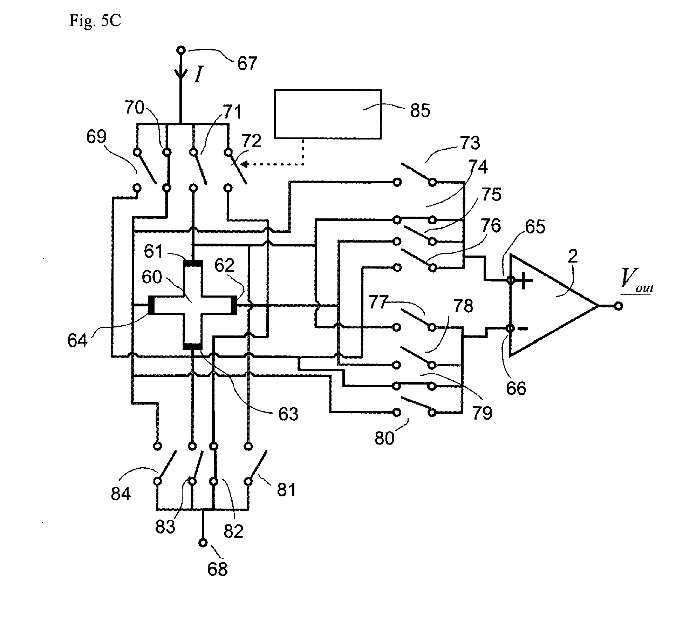

When changing from the second phase to the third phase the switches 69, 75, 77 and 81 are opened and the switches 70, 74, 79 and 82 are closed so that now the current fed to the first connection point 67 enters the Hall element 60 at terminal 64 and leaves the Hall element 60 at terminal 62. Fig. 5C shows the state of the switches in the third phase.

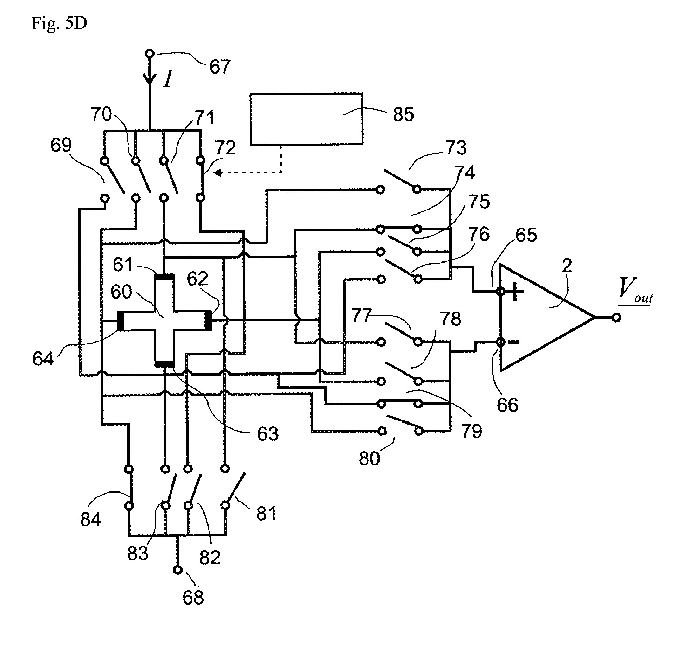

When changing from the third phase to the fourth phase the switches 70 and 82 are opened and the switches 72 and 84 are closed, so the current flows through the Hall element 60 in the reverse direction with regard to the third phase. The input terminals 65 and 66 of the amplifier 2 remained connected to the same terminals 64 and 62 of the Hall element. Fig. 5D shows the state of the switches in the fourth phase.

When changing from the fourth phase to the first phase of the next cycle the switches 72, 74, 79 and 84 are opened and the switches 71, 75, 80 and 83 are closed.

When changing from the first phase to the second phase and when changing from the third phase to the fourth phase two switches are opened and two switches are closed, i.e. four switches change their state. In contrast to this with the conventional spinning current method four switches are opened and four switches are closed at each change from one phase to the next phase, i.e. always eight switches change their state.

With this switching scheme the sign of the Hall-voltage in the four phases is +,-,+,-. However, the phases three and four may be exchanged. In this case the sign of the Hall-voltage in the four phases is +,-,-,+. The difference between the two cases is that the frequency of the Hall-voltage is different by a factor of two.

When the switching technique has to be applied for operating the Hall sensor according to the embodiments shown in figs. 1 to 3, any Hall element present in figs. 1 to 3 has to be replaced by a Hall element and 16 switches as shown for example in fig. 5A and a control means 85 for controlling the state of the switches of all Hall elements has to be added too.

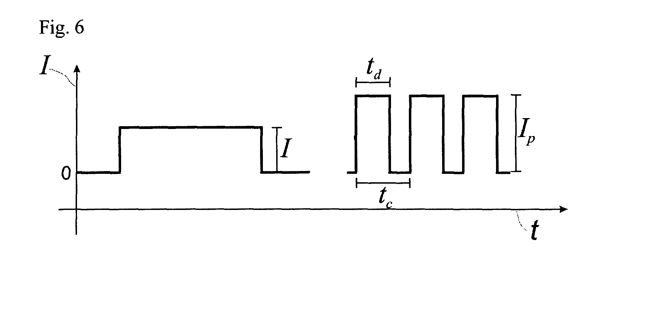

When operated with a battery, the Hall sensor is switched on for a measurement and then switched off again in order to safe energy. So the Hall sensor is only switched on for a short measurement cycle. Fig. 6 shows at the left-hand side the conventional way of feeding a constant current $I_C$ to the Hall element for such a measurement cycle. At the right hand side of Fig. 6 the pulsed mode of operation according to the invention is shown. During a measurement cycle the current is pulsed. The current has the amplitude $I_P$ during the time $t_d$ and disappears for the time $(t_c-t_d)$. The average current consumption may either be the same in both cases or the pulsed mode may be used to reduce the current consumption by a factor of $t_d/t_c$.

If the supply voltage $V_{sup}$ represents a limiting factor for the current $I_P$ a DC-DC converter can be used to increase the voltage supplied to the integrated circuit and thus the current $I_P$ supplied to the Hall element 1. With the example shown the measurement cycle comprises three pulses, but of course a measurement cycle may comprise more pulses.

It has been found that the signal to noise ratio S/N in this case is equal to

$$S/_N = \frac{S_V I R B \frac{t_c}{t_d}}{\sqrt{4kTR\frac{1}{2\pi t_d}}} = \frac{B}{4}\sqrt{\frac{t_d R}{k}}\,\frac{1}{T/2\pi}\frac{B}{R}\sqrt{\frac{1}{t_d}}\,I\frac{t_c}{\sqrt{t_d}} \tag{1}$$

where $S_V$ and R represent the voltage related sensitivity and the resistance of the Hall element, I the amplitude of the current, B the magnetic induction, $t_d$ the period in time when the current flows and $t_c$ the cycle time, k the Boltzmann constant and T the actual temperature. The S/N ratio increases when $t_d$ decreases. The optimum value for $t_d$ has to be determined with regard to the maximum possible peak current Ip, the power dissipation of the Hall element 1, the supply

voltage $V_{sup}$ and secondary effects that could decrease the sensitivity of the Hall sensor.

The presented improved spinning current sequence can be applied to the pulsed operation. That means that the four phases are executed in the time period $t_d$, followed by a period with no current before the next cycle starts. The bandwidth of the circuit must be increased accordingly to recover the modulated signal.

While embodiments and applications of this invention have been shown and described, it would be apparent to those skilled in the art having the benefit of this disclosure that many more modifications and combinations than mentioned above are possible without departing from the inventive concepts herein. The invention, therefore, is not to be restricted except in the spirit of the appended claims and their equivalents.

**Claims**

1. Hall sensor comprising at least one Hall element (1; 30; 31; 60) and at least one amplifier (2; 32; 33), **characterized in that** the at least one Hall element (1; 30; 31; 60) is placed inside the at least one amplifier (2; 32; 33) so that a current flowing through the at least one Hall element (1; 30; 31; 60) flows through a stage (8; 15; 16) of the at least one amplifier (2; 32; 33).

2. Hall sensor according to claim 1, further comprising sixteen switches (69-84) and control means (85) for switching the sixteen switches (69- 84) according to a predetermined switching scheme, wherein the switches (69- 84) serve to connect two terminals (61-64) of the at least one Hall element (60) with two terminals of a current supplying means and two other terminals (61-64) of the at least one Hall element (60) with two input terminals (65, 66) of the at least one amplifier (2; 32; 33), and wherein the switching scheme is composed of switching cycles having four phases following each other, **characterized in that** on change from the first phase to the second phase the switches connecting the Hall element (60) with the input terminals (65, 66) of the at least one amplifier (2; 32; 33) remain closed and four switches change their state so that a current direction of the current flowing through the Hall element (60) is reversed and **in that** on change from the third phase to the fourth phase the switches connecting the Hall element (60) with the input terminals (65, 66) of the at least one amplifier (2; 32; 33) remain closed and four switches change their state so that the current direction of the current flowing through the Hall element (60) is reversed.

3. Hall sensor according to claim 1, further comprising sixteen switches (69-84) and control means (85) for switching the sixteen switches (69- 84) according to a predetermined switching scheme, wherein the switches (69- 84) serve to connect two terminals (61-64) of the at least one Hall element (60) with two terminals of a current supplying means and two other terminals (61-64) of the at least one Hall element (60) with two input terminals (65, 66) of the at least one amplifier (2; 32; 33), and wherein the switching scheme is composed of switching cycles having five phases following each other, **characterized in that** on change from the first phase to the second phase the switches connecting the Hall element (60) with the input terminals (65, 66) of the at least one amplifier (2; 32; 33) remain closed and four switches change their state so that a current direction of the current flowing through the Hall element (60) is reversed and **in that** on change from the third phase to the fourth phase the switches connecting the Hall element (60) with the input terminals (65, 66) of the at least one amplifier (2; 32; 33) remain closed and four switches change their state so that the current direction of the current flowing through the Hall element (60) is reversed and **in that** no current flows through the Hall element (60) during the fifth phase.

4. Hall sensor comprising two Hall elements (30; 31) and two amplifiers (32; 33), **characterized in that** the Hall elements (30; 31) are connected in series and that the amplifiers (32; 33) are connected in series and **in that** two terminals of the first Hall element (30) are connected to two inputs of the first amplifier (32) and **in that** two terminals of the second Hall element (31) are connected to two inputs of the second amplifier (33).

5. Method for operating a Hall sensor comprising at least one Hall element (1; 30; 31; 60), wherein during a measurement cycle a current flows through the at least one Hall element (1; 30; 31; 60), **characterized in that** the current is pulsed.

6. Method according to claim 5, wherein the Hall element (1; 30; 31; 60) has four terminals (61, 62, 63, 64) and wherein sixteen switches (69-84) control the connection of the terminals (61, 62, 63, 64) of the Hall element (1; 30; 31; 60) with a current supplying means and two input terminals (65, 66) of an amplifier (2; 32; 33), **characterized in that** each current pulse is divided into four phases, that on change from the first phase to the second phase the switches connecting the Hall element (60) with the input terminals (65, 66) of the amplifier (2; 32; 33) remain closed and four switches change their state so that a current direction of the current flowing through the Hall element (60) is reversed and **in that** on change from the third phase to the fourth phase the switches connecting the Hall element (60) with the input terminals (65, 66) of the amplifier (2; 32; 33) remain closed and four switches change their state so that the current direction of the current flowing through the Hall element (60) is reversed.

7. Method for operating a Hall sensor comprising a Hall element (1; 30; 31; 60) and an amplifier (2; 32; 33), wherein the Hall element (1; 30; 31; 60) has four terminals (61, 62, 63, 64), wherein sixteen switches (69-84) control the connection of the terminals (61, 62, 63, 64) of the Hall element (1; 30; 31; 60) with a current supplying means and two input terminals (65, 66) of the amplifier (2; 32; 33), and wherein the switches (69-84) are switched according to a predetermined switching scheme composed of switching cycles, wherein each switching cycle comprises at least four phases following each other, **characterized in that** on change from the first phase to the second phase the switches connecting the Hall element (60) with the input terminals (65, 66) of the amplifier (2; 32; 33) remain closed and four switches change their state so that a current direction of the current flowing through the Hall element (1; 30; 31; 60) is reversed and **in that** on change from the third phase to the fourth phase the switches connecting the Hall element (60) with the input terminals (65, 66) of the amplifier (2; 32; 33) remain closed and four switches change their state so that the current direction of the current flowing through the Hall element (1; 30; 31; 60) is reversed.

Fig. 1

Fig. 2

Fig. 3

Fig. 4

Fig. 5A

Fig. 5B

Fig. 5C

Fig. 5D

Fig. 6

**European Patent Office**

## EUROPEAN SEARCH REPORT

Application Number

EP 05 10 0131

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 435 653 A (MATUI ET AL) 6 March 1984 (1984-03-06) * column 2, line 52 - line 65; figure 1 * | 1 | G01R33/07 |
| A | US 6 064 202 A (STEINER ET AL) 16 May 2000 (2000-05-16) * figure 11 * | 2,7 | |
| A | US 2003/128490 A1 (MOTZ MARIO) 10 July 2003 (2003-07-10) * page 2, right-hand column, line 61 - page 3, left-hand column, line 2 * | 3 | |
| A | US 2002/135358 A1 (SAGER RONALD E ET AL) 26 September 2002 (2002-09-26) * page 5, paragraph 47; figure 4 * | 4 | |
| A | US 2004/263148 A1 (TAKABATAKE NARITOMO 'JP!) 30 December 2004 (2004-12-30) * page 1, paragraph 23; figure 1 * | 1 | |

| TECHNICAL FIELDS SEARCHED (Int.Cl.7) |
|---|
| G01R H01L |

The present search report has been drawn up for all claims

| Place of search | Date of completion of the search | Examiner |
|---|---|---|
| The Hague | 6 September 2005 | Swartjes, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

Application Number

EP 05 10 0131

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-4, 7

☐ None of the further search fees have been paid within the fixed time limit. The present European search report has been drawn up for those parts of the European patent application which relate to the invention first mentioned in the claims, namely claims:

**European Patent Office**

**LACK OF UNITY OF INVENTION
SHEET B**

**Application Number**

EP 05 10 0131

The Search Division considers that the present European patent application does not comply with the requirements of unity of invention and relates to several inventions or groups of inventions, namely:

1. claims: 1-3, 7

      A switching scheme for a Hall sensor that reverses the current in going from phase 1 to phase 2 and from phase 3 to phase 4.
      ---

2. claim: 4

      Two Hall elements, connected in series.
      ---

3. claims: 5, 6

      Operating a Hall sensor with a pulsed current.
      ---

## ANNEX TO THE EUROPEAN SEARCH REPORT
## ON EUROPEAN PATENT APPLICATION NO.

EP 05 10 0131

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2005

| Patent document cited in search report | | Publication date | Patent family member(s) | | Publication date |
|---|---|---|---|---|---|
| US 4435653 | A | 06-03-1984 | JP | 57171211 A | 21-10-1982 |
| | | | JP | 1478624 C | 27-01-1989 |
| | | | JP | 57090176 A | 04-06-1982 |
| | | | JP | 63024268 B | 19-05-1988 |
| | | | CA | 1195735 A1 | 22-10-1985 |
| | | | DE | 3172782 D1 | 05-12-1985 |
| | | | EP | 0052981 A1 | 02-06-1982 |
| | | | KR | 8500358 B1 | 22-03-1985 |
| | | | KR | 8500359 B1 | 22-03-1985 |
| US 6064202 | A | 16-05-2000 | CA | 2236861 A1 | 12-03-1998 |
| | | | EP | 0859964 A2 | 26-08-1998 |
| | | | JP | 2000511642 T | 05-09-2000 |
| US 2003128490 | A1 | 10-07-2003 | DE | 10032527 C1 | 06-12-2001 |
| | | | WO | 0203088 A1 | 10-01-2002 |
| US 2002135358 | A1 | 26-09-2002 | AU | 1873202 A | 22-08-2002 |
| | | | CA | 2438423 A1 | 29-08-2002 |
| | | | CN | 1457434 A | 19-11-2003 |
| | | | EP | 1360515 A1 | 12-11-2003 |
| | | | JP | 2004519666 T | 02-07-2004 |
| | | | WO | 02067004 A1 | 29-08-2002 |
| US 2004263148 | A1 | 30-12-2004 | JP | 2005037369 A | 10-02-2005 |
| | | | CN | 1576857 A | 09-02-2005 |

EPO FORM P0459

For more details about this annex : see Official Journal of the European Patent Office, No. 12/82